(19) Europäisches Patentamt / European Patent Office / Office européen des brevets

(11) **EP 2 200 083 A2**

(12) **DEMANDE DE BREVET EUROPEEN**

(43) Date de publication:
**23.06.2010 Bulletin 2010/25**

(51) Int Cl.:
**H01L 27/146** (2006.01)

(21) Numéro de dépôt: **09179897.5**

(22) Date de dépôt: **18.12.2009**

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**
Etats d'extension désignés:
**AL BA RS**

(30) Priorité: **18.12.2008 FR 0858811**

(71) Demandeur: **COMMISSARIAT A L'ENERGIE ATOMIQUE**
**75015 Paris (FR)**

(72) Inventeur: **Fourches, Nicolas**
**91940 Les Ulis (FR)**

(74) Mandataire: **Lebkiri, Alexandre**
**Cabinet Camus Lebkiri**
**10 rue de la Pépinière**
**75008 Paris (FR)**

(54) **Détecteur à semiconducteur comprenant une grille flottante**

(57) La présente invention concerne un dispositif semiconducteur qui trouve une application particulièrement intéressante dans le domaine des détecteurs de lumière ou de particules chargées. Le dispositif selon l'invention (1) comporte une zone active (3) en matériau semiconducteur dopée selon un premier type de dopage, un drain (4) formée dans la zone active (3) et dopée selon un deuxième type de dopage, une source (5) formée dans la zone active (3) et dopée selon le deuxième type de dopage, une grille (6) isolée séparée de la zone active (3) par une couche isolante (7) et un caisson enterré (12) et dopé selon le deuxième type de dopage de sorte que la zone active (3) soit localisée entre la grille (6) et le caisson (12). Le dispositif (1) comporte en outre une grille flottante (13) formée dans la zone active (3) sous l'espace (16) existant entre le drain (4) et la source (5), la grille flottante (13) comportant des défauts introduisant des niveaux profonds dans la bande interdite, les niveaux profonds étant aptes à piéger des porteurs correspondant au premier type de dopage, la concentration de défauts dans la grille flottante (13) étant strictement supérieure à $10^{18}$ cm$^{-3}$.

Fig. 1

## Description

La présente invention concerne un dispositif semiconducteur. Le dispositif semiconducteur selon l'invention trouve une application particulièrement intéressante dans le domaine des détecteurs à semiconducteur pour la détection de lumière ou de particules chargées.

De nombreux types de détecteurs ou senseurs semi-conducteurs ont été proposés à des fins de détection de lumière ou de particules. La présente invention fait partie de la famille des photo-détecteurs. Ces photo-détecteurs dans les domaines du visible, de l'infrarouge ou des hautes énergies, aussi bien aux faibles qu'aux grandes vitesses de lecture, sont basés sur la génération de porteurs par la lumière ou les particules incidentes, qui interagissent avec un dispositif de sortie ou une circuiterie pour produire un signal électrique.

Un premier type de dispositif connu, dit dispositif à transfert de charge (DTC ou CCD « Charged Coupled Device » en anglais), consiste en un ensemble de capacités MOS (Métal Oxyde Semiconducteur) réalisées sur une même plaquette et dont les grilles sont très voisines les unes des autres. Le principe de fonctionnement est le suivant : créer sous l'une des grilles un puits de potentiel dans lequel on va piéger des porteurs minoritaires, qui sont créés par l'énergie de la lumière ou des particules chargées, puis par polarisation ad hoc de la grille voisine, transférer le paquet de charges sous celle-ci.

Une telle technologie pose cependant certaines difficultés. Ainsi, lors du transfert de charge d'une grille à l'autre jusqu'à la sortie du dispositif, les charges se déplacent à travers de très nombreuses grilles. A l'arrivée, une partie des charges sera définitivement perdue.

Une solution connue à ce problème consiste à utiliser un second type de dispositifs de détection, dit capteur d'image à pixel actif (ou APS « Active Pixel Sensor » en anglais). Contrairement aux dispositifs DTC, les dispositifs APS ne fonctionnent pas par transfert de charges. L'APS n'ayant pas de transfert de charges à réaliser vers une sortie, on comprend aisément que les défauts du CCD précédemment décrits sont éliminés. Le principe de l'APS consiste à associer, dans chaque pixel, un détecteur photosensible (photodiode, photoMOS,...) et un circuit d'amplification pour une sortie à faible impédance à travers un bus adressable. Ce dernier va aiguiller le signal amplifié résultant des charges photoélectriques intégrées vers une sortie à travers un bus colonne adressable. Ce principe ne rend donc plus nécessaires les nombreux transferts de charges de pixel en pixel des capteurs CCD. On notera que les senseurs à pixel actif APS sont particulièrement efficaces comme détecteur de lumière et dispositifs d'imagerie mais ont été également proposés et testés pour la détection de particules chargées.

La technologie des APS pose cependant également un certain nombre de difficultés.

En effet, une amplification interne (par avalanche par exemple) ou externe est requise. Un certain nombre de technologies ont été proposées pour remplir ces fonctions. La plus ancienne est la photodiode qui peut être utilisée en mode totalement déserté ou en mode photovoltaïque. La photodiode peut être constituée d'une simple jonction pn (asymétrique, avec hétérostructure ou simplement homo-structure), un contact Schottky (métal-semiconducteur) ou bien une structure pin très souvent utilisée dans les détecteurs pour la physique.

On constate donc que la technologie APS suppose des dispositifs supplémentaires pour la réalisation de l'amplification.

Une solution connue permettant de s'affranchir du problème précité consiste à utiliser une structure dite DEPFET (« Depleted p-channel field effet transistor ») qui forme une structure à la fois détectrice et amplificatrice. Un exemple d'une telle structure est décrite dans l'article « Design and technology of DEPFET pixel sensors for linear collider applications » (Nuclear Instruments and Methods in Physics Research A 511 (2003) 250-256 - Richter et al.). La structure DEPFET à canal p est un transistor FET à désertion de canal qui utilise une grille flottante enterrée constituée d'un caisson dopé n+. Un DEPFET comporte par ailleurs un contact inférieur dopé p+. Un photon ou une particule chargée crée en interagissant avec le détecteur des paires électrons-trous. Le DEPFET fonctionne sur la base d'une collection des électrons générés sur le caisson interne n+. Ces électrons sont générés dans la zone désertée située sous le caisson interne qui peut s'étendre jusqu'à 300 μm dans le matériau semiconducteur de la zone active. Cette région désertée est réalisée en appliquant une tension électrique élevée et négative au contact inférieur p+. Dès lors, le caisson n+ attire les électrons dans la zone déplétée inférieure et les localise de sorte que le DEPFET permet de moduler le courant drain source par les électrons collectés par ce caisson interne de commande.

Cependant, la mise en oeuvre d'une structure DEPFET pose également certaines difficultés.

Ainsi, le contact inférieur p+ du DEPFET nécessite une polarisation additionnelle (i.e. autre que la polarisation du transistor) avec une tension élevée de façon à obtenir un signal suffisant.

Par ailleurs, comme nous l'avons mentionné plus haut, les électrons permettant la modulation de courant sont situés dans une zone désertée localisée sous la grille interne : cette zone peut s'étendre jusqu'à 300 μm dans le matériau semiconducteur de la zone active. Cette dimension de plusieurs centaines de μm entraîne de fait une épaisseur de dispositif importante, épaisseur ayant un impact direct sur la dimension du pixel détecteur.

Enfin, la technologie du DEPFET est difficilement compatible avec une technologie MOS existante car elle nécessite l'utilisation d'un substrat semi-isolant de silicium de qualité détecteur avec un dopage résiduel très faible.

Dans ce contexte, la présente invention vise à fournir un dispositif semiconducteur particulièrement adaptée à la détection de la lumière ou de particules chargées, ledit dispositif permettant d'obtenir des détecteurs de dimensions plus faibles que les détecteurs connus, de fonctionner avec ou sans polarisation additionnelle et étant compatible avec une technologie MOS existante.

A cette fin, l'invention propose un dispositif semiconducteur, en particulier dans un détecteur à semi-conducteur, comportant :

- une zone active en matériau semiconducteur dopée selon un premier type de dopage ;
- une zone de drain formée dans ladite zone active et dopée selon un deuxième type de dopage ;
- une zone de source formée dans ladite zone active et dopée selon ledit deuxième type de dopage ;
- une zone de grille séparée de ladite zone active par une couche isolante ;
- un caisson enterré et dopé selon ledit deuxième type de dopage de sorte que ladite zone active soit localisée entre ladite zone de grille et ledit caisson ;

ledit dispositif étant **caractérisé en ce qu'**il comporte une zone de grille flottante formée dans ladite zone active sous l'espace existant entre ladite zone de drain et ladite zone de source, ladite zone de grille flottante comportant des défauts introduisant des niveaux profonds dans la bande interdite dudit matériau semiconducteur, lesdits niveaux profonds étant aptes à piéger des porteurs correspondant au dit premier type de dopage de sorte que l'état de charge de ladite zone de grille flottante soit modifié et le courant drain source varie du fait de la présence du potentiel supplémentaire sur ladite zone de grille flottante, la concentration de défauts dans ladite zone de grille flottante étant strictement supérieure à $10^{18}$ cm$^{-3}$.

Une concentration de défauts dans la zone de grille flottante strictement supérieure à $10^{18}$ cm$^{-3}$ permet d'obtenir une longueur de migration des porteurs correspondant au premier type de dopage inférieure à 1 $\mu$m et préférentiellement comprise dans le domaine [0,1 $\mu$m-1$\mu$m].

On entend par défauts introduisant des niveaux profonds dans la bande interdite des défauts non utilisés en tant que dopants, donneurs ou accepteurs, du matériau semiconducteur : en d'autres termes, il s'agit de défauts introduisant des niveaux d'ionisation plus proche du milieu de la bande interdite (i.e. niveaux permis de la bande interdite à énergie d'activation élevée). Il peut s'agir d'impuretés (par exemple le cuivre, le fer, le cobalt ou l'or dans le silicium) ou de défauts de structure (typiquement des zones lacunaires introduisant des niveaux proches du milieu de la bande interdite).

Le dispositif selon l'invention possède une structure identique à celle d'un transistor MOSFET à grille isolée à inversion et comporte en plus une zone de grille flottante qui piège des porteurs à partir des propriétés des niveaux profonds dus à des défauts ou des impuretés dans un semiconducteur cristallin. Pour réaliser une telle zone, il faut une zone ayant une concentration suffisante en pièges profonds, une concentration de $10^{18}$ cm$^{-3}$ formant la limite inférieure de concentration à ne pas atteindre pour maintenir un effet de piégeage suffisamment important.

Grâce à l'invention, en mode de fonctionnement comme détecteur de particules chargées ou de lumière, un photon ou une particule chargée crée en interagissant avec le dispositif semiconducteur selon l'invention des paires électrons-trous dans toute la zone active située sous la couche isolante de grille.

En partant de l'hypothèse que le premier type de dopage est un dopage p et le deuxième type est un dopage n, les trous générés le long de la trace de la particule ou du photon au niveau du caisson de type n et dans la zone active supérieure sont piégés dans la zone de grille flottante profonde alors que les électrons migrent dans la masse du semi-conducteur pour former un courant drain source. Pour assurer l'équilibre des courants les trous sont injectés et piégés sur la grille piégeante profonde ce qui augmente son efficacité, sa charge positive augmentant. Le fonctionnement du dispositif selon l'invention est donc basé sur l'état de charge de la zone de grille piégeante profonde qui piège les trous issus de la génération de paires électrons-trous par la lumière ou la particule chargée incidente pendant une durée suffisante (typiquement plusieurs $\mu$s). Le fait que cette grille soit enterrée (bien que flottante) dans la zone active de type p entraîne que les variations de potentiel de cette grille piégeante sont réduites ce qui permet le fonctionnement du dispositif. Le principe de fonctionnement de la zone de grille piégeante est de réduire la longueur de migration des porteurs par piégeage et rétention ce qui entraine une modification de l'état de charge de la grille piégeante et assure la modulation du courant dans le canal (couche d'inversion N au voisinage immédiat de la couche isolante de grille) du dispositif formant un MOSFET à grille isolée à enrichissement. Contrairement aux dispositifs de type DEPFET que sont basés sur un transistor FET à désertion de canal avec une grille piégeant le même type de porteurs (les électrons) que ceux formant le courant drain source, la grille piégeante du dispositif selon l'invention va attirer les trous, les électrons étant les porteurs formant le courant drain source.

La présence de défauts dans la grille piégeante profonde entraine une diminution de la longueur de migration des porteurs (trous pour un n-MOSFET).

Contrairement aux DEPFET, l'épaisseur totale du dispositif selon l'invention, peut être typiquement réduite à quelques microns. La zone active qui contribue à la détection est comprise entre le caisson et l'interface supérieure zone active / couche isolante : son épaisseur est de l'ordre de quelques microns (typiquement inférieure à 5 $\mu$m). Cette zone est partiellement désertée puisque le dispositif selon l'invention peut fonctionner soit sans polarisation sur le caisson soit avec une polarisation modérée.

Le dé-piégeage des porteurs piégés sur la grille piégeante se déroule avec une constante de temps beaucoup plus importante que le piégeage. Ceci a pour conséquence un signal détecté comprenant un temps de montée relativement court et une décroissance lente (jusqu'à quelques microsecondes à température T=27 °C. Cette décroissance constitue une remise à zéro naturelle et sa durée dépend du taux d'émission des porteurs des pièges profonds.

Comme nous l'avons mentionné, le dispositif peut fonctionner comme détecteur de lumière (ou de particules chargées) ; dans ce cas, la charge est intégrée sur la grille jusqu'à saturation ou jusqu'à l'équilibre entre piégeage et dépiégeage.

Le dispositif selon l'invention peut également fonctionner en tant que mémoire volatile : typiquement, dans le cas d'un n-MOS (trous piégés par la grille piégeante), on peut injecter des trous (typiquement via un contact substrat ayant une géométrie ad hoc) et créer ainsi une charge positive sur la grille piégeante profonde. Le dispositif agit donc en mémoire volatile, nécessitant un rafraichissement, car l'émission des porteurs supprime l'état écrit dans le dispositif. Il convient de noter à ce titre que les dispositifs tels que les mémoires non volatiles utilisant de façon connue le piégeage de charge diffère fondamentalement du dispositif selon l'invention en ce que le piégeage de charge se fait au sein d'un matériau isolant (le nitrure de silicium isolant étant par exemple utilisé comme matériau piégeant). La grille piégeante selon l'invention n'est pas diélectriquement couplée à l'électrode de grille via une zone diélectrique tunnel.

Il convient également de noter que les pièges liés aux niveaux profonds ont toujours été considérés comme un obstacle au fonctionnement correct des détecteurs plutôt qu'un principe possible d'opération (cf. à ce titre les articles « the role of secondary defects in the loss of energy resolution of fast-neutron-irradiated HPGe Gamma-ray detectors » Fourches et al. , IEEE Transactions on Nuclear Science, Volume 38, Issue 6, Dec. 1991 Page(s):1728 - 1735 et « Fast neutron irradiation of monolithic active pixel sensors dedicated to particle détection », Fourches et al., 8th International Workshop on Radiation Imaging Detectors, Nuclear Instruments and Methods in Physics Research Section A: Accelerators, Spectrometers, Detectors and Associated Equipment, Volume 576, Issue 1, 11 June 2007, Pages 173-177). Les difficultés technologiques dues aux pièges profonds dans un semi-conducteur cristallin sont surtout liées au manque de connaissances sur leurs propriétés fondamentales, aspect qui progresse rapidement surtout pour le silicium cristallin. Ceci permet maintenant de proposer des dispositifs qui utilisent leurs propriétés intrinsèques de piégeage de charge.

Par ailleurs, aucun dispositif basé sur ce principe n'était envisageable avant l'avènement de procédés microélectroniques submicroniques, pour des raisons liées aux quantités de charge générées par rapport aux capacités parasites.

Le dispositif selon l'invention présente donc les avantages suivants :

- réduction à un seul dispositif, qui a le rôle de détecteur et d'amplificateur (en transconductance) ;
- utilisation de procédés submicroniques qui permettent d'obtenir une densité d'intégration très importante ;
- les deux remarques précédentes permettent de réaliser des pixels de taille réduite ce qui autorise la conception de détecteurs à très petite résolution spatiale (typiquement inférieure à 1 $\mu$m).
- les réductions de dimensions permettent d'envisager une simplification du traitement des données, donc une simplification de l'électronique de lecture, qui peut être simplement binaire, dans le cas d'une application à la détection de particules ionisantes ;
- le dispositif selon l'invention permet de réaliser un détecteur rapide à auto-remise à zéro, par le simple effet de l'émission thermique des porteurs de charge, par les niveaux profonds du semi-conducteur ;
- cette émission rapide à température ambiante permet de détecter de la lumière en continu avec un temps de réponse bref (< quelques $\mu$s).

On notera par ailleurs que le dispositif selon l'invention est compatible avec une technologie CMOS puisqu'on peut fabriquer un dispositif complémentaire en utilisant des pièges à électrons sur une technologie complémentaire (pour laquelle le dopage n remplace le dopage p et réciproquement). Les pièges de trous deviennent alors des pièges d'électrons.

Le dispositif semiconducteur selon l'invention peut également présenter une ou plusieurs des caractéristiques ci-dessous, considérées individuellement ou selon toutes les combinaisons techniquement possibles :

- ledit caisson enterré a une forme de puits avec une partie basse et une partie latérale, ladite partie latérale entourant ladite zone de grille flottante ;
- ladite zone de grille flottante est à proximité dudit espace existant entre ladite zone de drain et ladite zone de source ;
- la concentration de défauts dans ladite zone de grille flottante est supérieure ou égale à $10^{19}$ cm$^{-3}$.
- la concentration de défauts dans ladite zone de grille flottante est inférieure ou égale à $10^{21}$ cm$^{-3}$ ;
- la concentration de défauts profonds dans ladite zone de grille flottante est sensiblement égale à $10^{20}$ cm$^{-3}$ ;
- la concentration de défauts profonds décroît de ladite zone de grille flottante jusqu'à l'interface entre ladite zone active et ladite couche isolante pour atteindre une concentration inférieure ou égale à $10^{18}$ cm$^{-3}$ ;
- le matériau semiconducteur est du silicium cristallin ;
- ledit matériau semiconducteur est du silicium amorphe ;

- ladite zone de grille flottante est située à une distance comprise entre 0,2 μm et 5 μm de l'interface entre ladite zone active et ladite couche isolante ; en tout état de cause, la zone de grille flottante doit être localisée sous le canal induit (ou couche d'inversion) du dispositif selon l'invention ;
- une première partie de l'épaisseur de ladite zone de grille flottante recouvre ledit caisson enterré et l'autre partie de l'épaisseur de ladite zone de grille flottante se situe au-dessus dudit caisson enterré ;
- ladite zone de grille flottante se situe pour une moitié de son épaisseur sur ledit caisson enterré ;
- les différentes zones et le caisson sont formés sur un substrat semiconducteur ou un substrat SOI ;
- ledit premier type de dopage est un dopage p et ledit second type de dopage est un dopage n de sorte que les porteurs piégés dans ladite zone de grille flottante sont des trous ;
- le dispositif selon l'invention comporte au moins un contact pour la polarisation dudit caisson enterré ;
- ladite zone de grille isolée a une longueur inférieure ou égale à 0,2 μm ;
- ladite zone active a une largeur inférieure ou égale à 1 μm ;
- lesdits défauts introduisent des niveaux profonds ayant une section efficace de capture des porteurs issus dudit premier type de dopage supérieure à $10^{-14}$ cm$^2$ ;
- l'énergie d'activation des défauts profonds est de comprise entre 0.3 et 0.5 eV ;
- le dispositif selon l'invention comporte un contact pour l'injection de porteurs correspondant au dit premier type de dopage dans ladite zone active.

La présente invention a également pour objet un procédé de fabrication d'un dispositif selon l'invention **caractérisé en ce que** ladite zone de grille flottante est obtenue par implantation ionique (par exemple de silicium, de germanium, de fer ou d'hydrogène dans le silicium).

Le procédé selon l'invention peut également présenter une ou plusieurs des caractéristiques ci-dessous, considérées individuellement ou selon toutes les combinaisons techniquement possibles :

- ladite implantation ionique est suivie d'un recuit thermique ;
- ladite implantation ionique est réalisée en utilisant deux énergies d'implantation différentes.

La présente invention a également pour objet un procédé de fabrication d'un dispositif selon l'invention **caractérisé en ce que** ladite zone de grille flottante est obtenue par épitaxie.

Avantageusement, ladite zone est soumise à un bombardement électronique ou un traitement par plasma.

La présente invention a également pour objet un détecteur comportant un dispositif selon l'invention.

La présente invention a également pour objet une mémoire volatile comportant un dispositif selon l'invention.

D'autres caractéristiques et avantages de l'invention ressortiront clairement de la description qui en est donnée ci-dessous, à titre indicatif et nullement limitatif, en référence aux figures annexées, parmi lesquelles :

- la figure 1 représente schématiquement un dispositif semiconducteur selon un premier mode de réalisation l'invention ;
- la figure 2 illustre un schéma de bandes correspondant au dispositif selon l'invention;
- la figure 3 illustre schématiquement un dispositif selon un second mode de réalisation de l'invention;
- la figure 4 représente le profil de concentration des défauts introduisant des niveaux profonds dans le dispositif selon l'invention ;
- la figure 5 est une représentation symbolique du dispositif selon l'invention ;
- la figure 6 illustre schématiquement un élément détecteur d'image comportant un dispositif selon l'invention.

Dans toutes les figures, les éléments communs portent les mêmes numéros de référence.

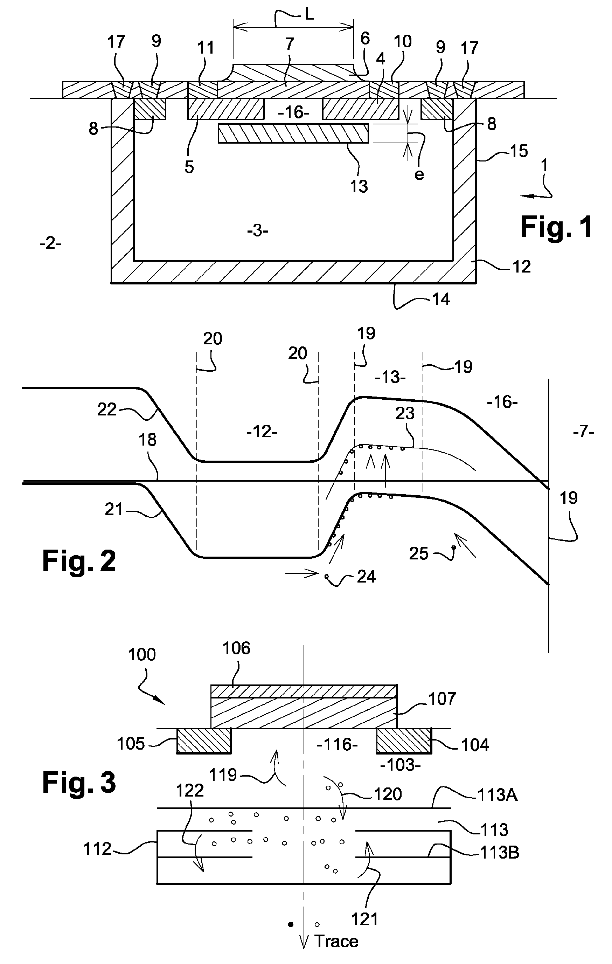

La figure 1 représente schématiquement un dispositif 1 semiconducteur selon un premier mode de réalisation de l'invention.

Le dispositif 1 est réalisé à partir d'un substrat 2 qui peut être un substrat massif ou épitaxié. Le substrat peut également être un substrat silicium sur isolant SOI (« Silicon On Insulator »). Typiquement, le substrat é est ici un substrat en silicium de type p.

Le dispositif 1 comporte :

- le substrat 2 de type p ;
- une zone 3 active dopée p intégrée au substrat 3 ;
- une zone de drain 4 formée dans la zone active 3 et fortement dopée n (i.e. dopée n+) ;
- une zone de source 5 formée dans la zone active 3 et dopée n+ ;
- une zone de grille 6 isolée, typiquement en polysilicium, séparée de la zone active 3 par une couche isolante 7 en SiO$_2$ située en partie supérieure du substrat 2 ;
- deux zones 8 fortement dopée p (i.e. dopée p+) situées respectivement de part et d'autre de la zone de drain 4 et de la zone de source 5 ;
- deux contacts métalliques 9 situés en partie supérieure du substrat 2 assurant respectivement le contact avec les deux zones p+ 8 ;
- un contact métallique 10 de zone de drain 4 situé en partie supérieure du substrat 2;
- un contact métallique 11 de zone de source 5 situé en partie supérieure du substrat 2;

- un caisson (désigné également par la suite par le terme puits) 12 enterré (« deep well » en anglais) dans le substrat 2 et dopé n ;
- une zone de grille flottante 13 formée dans la zone active 3 (nous désignerons cette zone de grille flottante 13 par le terme grille piégeante 13 ou « deep trapping gate » en anglais dans la suite de la description).

Le caisson n enterré 12 comporte une partie basse 14 horizontale et une partie 15 latérale ; la partie latérale 15 délimite la partie active 3 et entoure donc la grille piégeante 13. La partie latérale 15 débouche sur deux contacts métallique 17. Le caisson 12 a par exemple la forme d'un anneau de confinement dont la partie basse 14 a une épaisseur typiquement inférieure ou égale à 0,2 $\mu$m environ et se trouve à une profondeur variant de 0,5 $\mu$m à quelques $\mu$m sous la couche 7 d'oxyde grille (typiquement 1 $\mu$m environ).

La grille piégeante 13 est située sous l'espace 16 existant entre la zone de drain et la zone de source dans laquelle se forme le canal n induit (ou couche d'inversion) si on porte la zone de grille 6 à un potentiel positif. La grille piégeante est positionnée très près de l'espace 16.

La grille piégeante 13 est réalisée à partir de défauts ou d'impuretés introduisant des niveaux profonds dans la bande interdite du silicium. On entend par défauts ou impuretés introduisant des niveaux profonds dans la bande interdite des défauts non utilisés en tant que dopants, donneurs ou accepteurs, du matériau semiconducteur : en d'autres termes, il s'agit de défauts introduisant des niveaux d'ionisation plus proche du milieu de la bande interdite (i.e. niveaux permis de la bande interdite à énergie d'activation élevée).

On notera que, selon ce mode de réalisation, la grille piégeante 13 est située entre l'espace 16 et la partie basse 14 du caisson 12 sans recouvrement entre la grille piégeante 13 et la partie basse 14.

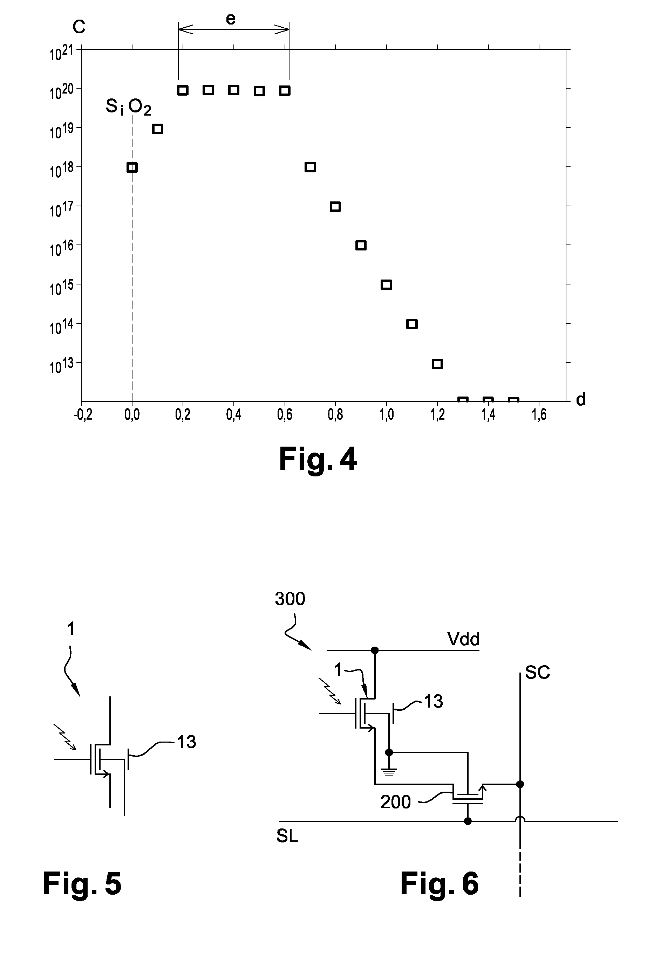

Pour réaliser la grille piégeante 13, il faut obtenir une zone ayant une concentration suffisante en niveaux profonds. Le profil recherché de concentration en niveaux profonds est représenté en figure 4. Ce profil représente la concentration C en cm$^{-3}$ de pièges profonds en fonction de la distance d en $\mu$m par rapport à la couche isolante 7 d'oxyde. Ce profil comporte un plateau de concentration correspondant sensiblement à l'épaisseur e de la grille piégeante 13 (environ 0,4 $\mu$m). On constate que la concentration C diminue très vite de part et d'autre du plateau, notamment lorsqu'on se rapproche de la couche isolante 7 : cette diminution est importante car il convient de ne pas étendre la zone piégeante 13 vers la zone 16 de canal. La zone piégeante 13 est ici située à environ 0,2 $\mu$m de la couche isolante 7. On peut toutefois envisager une zone piégeante un peu plus éloignée de la couche isolante 7 (typiquement jusqu'à 2 $\mu$m voire 5 $\mu$m). La concentration de défauts profonds dans la zone de grille flottante est ici sensiblement égale à 10$^{20}$ cm$^{-3}$

(en tout état de cause strictement supérieure à 10$^{18}$ cm$^{-3}$ et préférentiellement supérieure ou égale à 10$^{19}$ cm$^{-3}$) et décroit de la zone de grille flottante jusqu'à l'interface Si/SiO2 (interface couche active / couche isolante) pour atteindre une concentration inférieure ou égale à 10$^{18}$ cm$^{-3}$ avec une épaisseur de la couche isolante 7 en SiO2 variant de 5 nm à 10 nm.

Afin de parvenir à un tel profil, on peut utiliser une implantation ionique soit pour obtenir directement des défauts profonds soit pour obtenir des impuretés profondes. Pour obtenir des défauts sans qu'il y ait dopage, il convient d'implanter des ions neutres (non dopants).

L'implantation d'impuretés profondes (par exemple le Fe, le Co, le W, l'Au ou le Cu) dans le silicium implique une étape technologique supplémentaire de recuit ; les dégradations du réseau cristallin engendrées par l'implantation diminuent en effet drastiquement les caractéristiques électriques du semiconducteur et ce recuit permet d'activer électriquement ces impuretés. Typiquement, la création d'impuretés profondes peut par exemple être obtenue par une implantation de Fe dans le Si suivie d'un recuit (cf. notamment l'article « Electrical properties of deep silver and iron related centres in silicon », Pearton et al., J. Phys. C: Solid State Phys., 17 (1984) 6701-6710).

Comme mentionné plus haut, on peut également réaliser le profil recherché en créant des défauts profonds de structure (par exemple des défauts lacunaires) sans recuit. Plus spécifiquement, on peut implanter des ions hydrogène H+ avec l'énergie adéquate (typiquement comprise entre 10 keV et 50 keV selon les conditions recherchées), la concentration en lacunes pouvant atteindre environ 10$^{20}$ cm$^{-3}$ (cf. notamment l'article « vacancy-hydrogen interaction in H-implanted Si studied by positron annihilation », Brusa et al., Phys. Rev. B , Vol 49,N°11,15 March 1994-1,7271-7280).

L'implantation de silicium à fortes doses peut être aussi envisagée (cf. notamment l'article « Evolution from point to extended defects in ion implanted silicon », Benton et al., J. Appl. Phys. 82 (1), 1 July 1997, 120-125) de même que l'implantation de Ge ou d'un autre ion neutre.

L'obtention du profil ad hoc de concentration en défauts peut également nécessiter le recours à une implantation au travers du substrat par l'arrière, afin d'obtenir le résultat désiré sans recuit ; il peut alors s'avérer utile de travailler avec des énergies d'implantation élevées et un substrat aminci.

Une alternative pour obtenir le profil ad hoc peut consister à utiliser deux énergies d'implantation différentes. Une première implantation à haute énergie permet de créer une zone de pièges profonds et une deuxième implantation à plus basse énergie permet d'obtenir la concentration souhaitée (typiquement 10$^{20}$ cm$^{-3}$) dans la zone de grille piégeante et réduire la concentration en pièges profonds lorsqu'on se rapproche du substrat. On réduit ainsi la concentration en défauts à la surface (défauts primaires de nature lacunaire) par une implantation faite à deux énergies différentes (haute énergie pour créer une zone de pièges profonds, par exemple une implantation de Si à une énergie supérieure à 100 keV) et basse énergie pour limiter leur concentration des défauts profonds dans la zone active au-dessus de la grille piégeante (par exemple une implantation de Si à une énergie de l'ordre de 10 keV).

La réalisation de la zone de grille piégeante par implantation implique donc une étape (implantation ionique seule) à deux étapes technologiques supplémentaires (implantation ionique et recuit) par rapport à un procédé standard de réalisation d'un MOSFET à grille isolée, étapes qui sont tout à fait compatibles avec les procédés des technologies actuelles.

Le dispositif 1 selon l'invention est réalisé à partir d'une technologie submicronique avec une longueur L de grille inférieure ou égale à 0.5 $\mu$m. Le dispositif 1 selon l'invention possède une structure de transistor MOSFET de géométrie linéaire ou fermée à grille isolée à enrichissement de canal n comprenant une couche 7 d'oxyde de grille d'épaisseur limitée (typiquement inférieure ou égale à 10 nm).

Le substrat 2 (épitaxié ou non épitaxié) possède un dopage p en zone active 3 avec une concentration de dopants comprise entre $10^{15}$ cm$^{-3}$ et $10^{16}$ cm$^{-3}$.

Une implantation sous la couche isolante 7 de grille au moyen d'un dopant approprié peut être nécessaire pour contrôler la tension de seuil.

Les contacts substrat 8 permettent de relier le substrat à la masse (par exemple via une liaison avec la zone de source 4) pour éviter les polarisations de substrat 2.

Le puits 12 dopé n enterré (ou caisson) est localisé sous la grille ; ce type de caisson est déjà utilisé dans certains transistors MOS et est destiné à mieux isoler chaque transistor des autres dispositifs. Le document de brevet US5943595 (cf. notamment les figures 1 (a) à 1(c) de ce document) décrit un procédé de réalisation de ce type caisson 12 par une succession d'étapes de masquage et d'implantation d'une impureté dopante (suivie d'un recuit). Il est préférable de localiser le caisson 12 près de la surface supérieure du substrat 2 (typiquement à quelques $\mu$m) ce qui limite le nombre de procédés primaires (front-end process).

On notera que la zone 13 de grille piégeante où se trouvent présents des niveaux profonds est préférentiellement réalisée après le processus primaire (front end) de fabrication et avant la réalisation du processus back-end (métallisation, contacts, passivation, encapsulation).

On trouvera ci-dessous d'autres ordres de grandeurs typiques pour la réalisation du dispositif 1 selon l'invention (ces ordres de grandeurs sont donnés à titre purement illustratif et non limitatif) :

- la largeur du dispositif 1 est préférentiellement inférieure à 1 $\mu$m ;
- la longueur de la zone de grille 6 est inférieure ou égale à 0,5 $\mu$m, sans qu'il y ait de limite inférieure apparente ;

- l'épaisseur totale de la zone active 3 est supérieure à 8 $\mu$m pour obtenir une charge suffisante et inférieure à l'épaisseur totale du substrat 2. ;
- la concentration de défauts dans la grille piégeante 13 profonde est préférentiellement comprise entre $10^{19}$ cm$^{-3}$ et $10^{21}$ cm$^{-3}$ et en tout état de cause strictement supérieure à $10^{18}$ cm$^{-3}$. En deçà le piégeage dans cette grille 13 est insuffisant. Au dessus le passage à l'état amorphe du silicium en surface peut modifier le fonctionnement du dispositif 1.
- L'énergie d'activation des défauts profonds est de préférence comprise entre 0.3 et 0.5 eV (pour une largeur de bande interdite du silicium égale à 1,11 eV) avec des sections efficaces de capture : $\sigma_p > 10^{-14}$ cm$^2$ et $\sigma_n < 10^{-17}$ cm$^2$, dans le cadre décrit ici, ceci afin d'obtenir des temps de remise à zéro appropriés (nous reviendrons sur ce point par la suite en référence à la description du mode de fonctionnement du dispositif 1. Une énergie d'activation faible entraine une émission rapide, toutes choses étant égales par ailleurs (température, sections efficaces de capture). On notera que, dans le cas d'un dispositif complémentaire en inversant les types de dopage, c'est-à-dire en utilisant des pièges à électrons sur une technologie complémentaire (pour laquelle le matériau n remplace le matériau p et réciproquement), les pièges de trous deviennent alors des pièges d'électrons et les sections efficaces de capture sont inversées ; on a donc : $\sigma_n > 10^{-14}$ cm$^2$ et $\sigma_p < 10^{-17}$ cm$^2$.

Nous allons décrire dans ce qui suit le fonctionnement du dispositif 1 en mode détecteur de lumière ou de particules chargées.

Nous partons pour cela de l'hypothèse que le dispositif 1 est polarisé de façon permanente ; en d'autres termes, on porte la zone de grille 6 à un potentiel positif par rapport au substrat 2 et on alimente le dispositif 1 avec une tension drain source positive. Le condensateur constitué par la zone de grille 6 et la zone active 3 se charge de telle manière que les charges négatives (les électrons) apparaissent dans ce dernier au contact de la couche isolante 7 dans la zone située entre le drain 4 et la source 5. On crée ainsi, de façon classique, une couche d'inversion n au voisinage immédiat de la couche isolante 7. Cette couche d'inversion (ou canal n induit) établit la conduction entre les zones de drain 4 et de source 5.

L'exposition du dispositif 1 à un flux de photons ou de particules chargées va entraîner la génération de paires électrons-trous dans toute la zone active 3.

Ces paires électrons-trous vont être séparées : les trous générés le long de la trace de la particule dans le puits n 12 et la zone active 3 sont piégés dans la grille piégeante profonde 13 alors que les électrons migrent de la masse du semi-conducteur vers le canal pour s'écouler entre la zone de drain 4 et la zone de source 5.

Ce phénomène est illustré par la figure 2 qui représente un schéma de bandes correspondant au dispositif 1. La ligne horizontale 18 représente le niveau de Fermi. La ligne verticale 19 représente l'interface entre la zone active 3 (et plus spécifiquement la zone drain source 16) et la couche isolante 7. Les lignes pointillées 19 délimitent sensiblement la zone de grille piégeante 13 et les lignes pointillées 20 délimitent sensiblement le caisson n 12. Le tracé inférieur 21 correspond au bord supérieur de la bande de valence du semiconducteur. Le tracé supérieur 22 correspond au bord inférieur de la bande de conduction du semiconducteur. Un niveau profond 23 de trou est représenté au milieu de la bande interdite, dans la grille piégeante profonde. On constate que les trous vont être piégés dans le niveau profond 23 qu'ils soient situés dans le puits 12 qui repoussent les trous (trous 24 qui remontent vers le niveau profond 23) ou au niveau du canal 16 (trous 25 qui remontent vers le niveau profond 23). Le puits 12 a de préférence la forme d'un anneau de confinement (partie basse circulaire 14 et partie latérale cylindrique 15) afin d'éviter la diffusion latérale des trous et de les faire piéger dans la grille piégeante 13. Le puits 12 peut être flottant ou polarisé à un potentiel fixe via les contacts 9 de manière à augmenter l'efficacité. On note ici que le dispositif selon l'invention peut fonctionner sans polarisation additionnelle du puits 12.

La grille piégeante 13 permet de créer une jonction n+p qui crée une zone désertée orientée vers la surface supérieure et le canal.

Le piégeage des trous sur la grille piégeante 13 va augmenter la charge positive de la grille piégeante 13. Dès lors, le courant drain source est modulé par la charge de la grille piégeante 13. On peut concevoir la grille piégeante 13 comme une grille arrière qui modifie la tension de seuil du transistor 1. La figure 5 est à ce titre une représentation symbolique du dispositif 1 selon l'invention, celui-ci comprenant une grille piégeante profonde enterrée 13 illustrée à l'arrière du dispositif 1.

Comme on travaille initialement avec une tension de grille constante, le courant drain source va varier de par la présence de ce potentiel supplémentaire sur la grille piégeante 13.

La grille piégeante profonde 13 peut être caractérisée par des dérivés de méthodes usuelles comme la ME (Microscopie Electronique), la RPE (Résonance Paramagnétique Electronique), la DLTS (« Deep Level Transient Spectroscopy »), la TCT (« Time resolved Current Transients »), etc... applicables aux structures MOS.

La remise à zéro du dispositif 1 agissant comme détecteur se fait naturellement par décharge de la grille piégeante 13. Le dé-piégeage se déroule avec une constante de temps beaucoup plus importante que le piégeage. On obtient donc un signal détecté comprenant un temps de montée relativement court et une décroissance lente (jusqu'à quelques microsecondes à température T=27 °C). Cette décroissance constitue une remise à zéro naturelle et sa durée dépend du taux d'émission des porteurs des pièges profonds. Dans le cas du dispositif 1 fonctionnant comme détecteur de lumière, la charge est donc intégrée sur la grille piégeante 13 jusqu'à saturation ou jusqu'à l'équilibre entre piégeage et dé-piégeage. C'est le mode de fonctionnement en détecteur de lumière (ou de particules chargées) pour lequel le courant drain - source est fonction monotone et continue de l'éclairement (ou de l'exposition à des particules chargées) du dispositif 1. On peut également utiliser des électrodes faiblement dopées n pour injecter des électrons et permettre une remise à zéro plus rapide. On peut également injecter des électrons à partir de la zone de drain 4 ou de la zone de source 5 pour recombiner les trous piégés et assurer une réinitialisation du dispositif 1.

En résumé, le fonctionnement du dispositif 1 est basé sur l'état de charge de la grille piégeante profonde 13 qui piège les trous issus de la génération de paires électrons-trous par la lumière ou la particule chargée incidentes pendant une durée suffisante (plusieurs $\mu$s). Le fait que cette grille soit enterrée (bien que flottante) dans le silicium de type p entraîne que les variations de potentiel de cette grille sont réduites ce qui permet le fonctionnement du dispositif.

Des simulations réalisées avec un logiciel tel que TCAD ATLAS® (Silvaco® PISCES, Silvaco® Software Package) permettent de valider le principe de fonctionnement du dispositif. Le principe de fonctionnement de la grille piégeante est de réduire la longueur de migration des porteurs par piégeage et rétention ce qui entraine une modification de l'état de charge de la grille piégeante et ainsi assurer la modulation du courant dans le canal (couche d'inversion). En particulier la présence de défauts dans la grille piégeante profonde entraine une diminution de la longueur de migration des porteurs (trous pour un n-MOSFET).

Pour un seul niveau profond de concentration $N_t$ on a une longueur de capture en diffusion Lp donnée par la formule :

$$L_p = (D_p \tau_p)^{1/2}$$

où $D_p$ est la constante de diffusion et $\tau_p$ est la durée de vie.

La durée de vie $\tau_p$ est donnée par la formule :

$$1/\tau_p = N_t v_{th} \sigma_p$$

où Nt est la densité de niveaux profonds, vth est la vitesse thermique et $\sigma_p$ est la section efficace de capture de trous par les niveaux profonds.

On constate donc que la longueur de capture en diffusion diminue lorsque le produit $N_t \sigma_p$ augmente.

La longueur de capture en dérive $L_d$ (lorsqu'un champ est appliqué) est donnée par la formule :

$$L_d = (N_t \sigma_p)^{-1}.$$

On constate donc que la longueur de dérive $L_d$ se comporte de la même façon que la longueur de capture en diffusion et diminue lorsque le produit $N_t \sigma_p$ augmente.

Ceci entraine que la concentration en pièges doit dépasser une certaine limite pour assurer le fonctionnement de la grille piégeante profonde. A cet effet, comme nous l'avons vu auparavant, la concentration de défauts dans la grille piégeante 13 profonde est comprise entre $10^{19}$ cm$^{-3}$ et $10^{21}$ cm$^{-3}$ et préférentiellement sensiblement égale à $10^{20}$ cm$^{-3}$.

En revanche le fait que le dispositif soit basé sur un transistor MOSFET à inversion n'entraine aucune limitation supérieure de principe au produit $N_t \sigma_p$ dans le canal du MOS : (la durée de vie ne joue pas de rôle majeur dans les équations des MOSFETS).

En particulier si $N_t = 10^{20}$ cm$^{-3}$ et $\sigma_p=10^{-3}$ cm$^2$ alors $L_d = 0,1$ $\mu$m et $1/\tau_p = N_t V_{th} \sigma_p = 10^{14}$ s$^{-1}$, soit $L_p = 0,34$ $\mu$m ; ces longueurs correspondent à des longueurs de piégeage de moins d'un micron ce qui est particulièrement avantageux pour un bon fonctionnement du dispositif. En dehors de la grille piégeante profonde on doit limiter la concentration en pièges profonds pour assurer un fonctionnement adéquat du dispositif (et notamment éviter une amorphisation locale du semiconducteur). De plus les simulations montrent que le fonctionnement est optimum lorsque les niveaux pièges se situent près du milieu de la bande interdite.

La figure 3 illustre schématiquement un dispositif 100 selon un second mode de réalisation de l'invention. Ce dispositif 100 est davantage adapté à une application de détection de lumière que de particules chargées. Par soucis de simplification, certains éléments non nécessaires à la compréhension du dispositif 100 ont été omis.

Tout comme le dispositif 1 de la figure 1, le dispositif 100 comporte :

- une zone 103 active dopée p intégré au substrat ;
- une zone de drain 104 formée dans la zone active 103 et dopée n+ ;
- une zone de source 105 formée dans la zone active 103 et dopée n+ ;
- une zone de grille 106 isolée, typiquement en polysilicium, séparée de la zone active 103 par une couche isolante 107 en SiO$_2$ située en partie supérieure du substrat ;
- un caisson 112 enterré (« deep n well » en anglais) dans le substrat et dopé n ;
- une zone de grille flottante piégeante 113 formée dans la zone active 103.

Contrairement au dispositif 1 de la figure 1, La grille piégeante profonde 113 se situe pour moitié de son épaisseur (partie 113B) sur le caisson n 112 et pour l'autre moitié sur la zone p 103 située dans la partie supérieure. Elle se situe au milieu de la zone de transition n/p.

Le dispositif 1 de la figure 1 est plus adapté à une application pour la détection de trace de particules chargées pour lequel il faut augmenter l'épaisseur de la zone active 3 (et donc éloigner le caisson 12 tout en polarisant éventuellement ce dernier via les contacts 17 pour réaliser un gradient de potentiel) afin d'augmenter la sensibilité du dispositif 1; cet éloignement du caisson est moins utile dans le cas d'un détecteur de photons tel que le dispositif 100 et on peut placer le caisson n très près de la grille piégeante p : dans le cas du dispositif 100 de la figure 3, le caisson 112 se superpose jusqu'à la moitié de son épaisseur à la grille piégeante 113. La polarisation du caisson 113 est également moins utile et il n'est donc pas nécessaire de prévoir des contacts tels que les contacts 17 représentés en figure 1 pour polariser le caisson.

On notera que, dans tous les cas (dispositif 1 ou 100), la grille piégeante 13 ou 113 doit être très proche du canal 16 ou 116.

Il est également souhaitable que la grille piégeante 113 soit entourée par des parties latérales (non représentées) prolongeant latéralement le caisson 112 et permettant de réaliser un meilleur confinement des trous.

Concernant le fonctionnement du dispositif 100, il est identique au fonctionnement du dispositif 1. La flèche représente la trace des photons.

L'exposition du dispositif 100 aux photons va entraîner la génération de paires électrons-trous dans toute la zone active 103.

Ces paires électrons-trous vont être séparées : les trous générés le long de la trace de la particule dans le puits n 112 (cf. flèche 121) et dans la zone active 103 (flèche 120) sont piégés dans la grille piégeante profonde 13 alors que les électrons générés dans la zone active 103 (flèche 119) migrent de la masse du semi-conducteur vers le canal 116 pour s'écouler entre la zone de drain 104 et la zone de source 105. Les électrons générés au niveau du puits n 112 (flèche 122) restent confinés sur celui-ci ; on notera que lorsque le puits est polarisé positivement par rapport à la masse, les électrons générés au niveau du puits s'écoulent vers l'électrode de polarisation positive prévue à cet effet.

Afin de fournir quelques éléments chiffrées permettant de fixer les principes généraux, on peut considérer que le nombre total de pièges profonds chargés dans la grille piégeante est de l'ordre de 1000, ceci est raisonnable compte tenu des concentrations en pièges et des dimensions du transistor (1$\mu$m de largeur et 0,2 $\mu$m de longueur de grille). Ainsi, avec des capacités $C_{ox}$ (capacité grille/oxyde de grille/silicium) environ égale à $1,06 \times 10^{-12} \times 0,2 \times 10^{-8}/510^{-7}$ F soit $4,24 \times 10^{-15}$ F pour une épaisseur de grille de 5nm et une capacité $C_{Si}$ (capacité canal/grille piégeante) environ égale à

$1,06 \times 10^{-12} \times 0,2 \times 10^{-8} / 10^{-5}$ F pour une grille piégeante située à 0.1 $\mu$m du canal soit $2.1 \times 10^{-16}$ F, on peut obtenir une charge sur la grille piégeante $\Delta Q_{Si}$ égale à 1000 électrons. Ceci induit une charge image identique sur la grille de commande : la variation de tension de seuil est alors $\Delta V_{th} = \Delta Q_{Si} / C_{Ox}$ environ égale à 0.038 V. Ceci indique qu'une zone piège chargée est suffisante pour changer de manière significative la tension de seuil du dispositif et par conséquent pour moduler le courant drain-source.

$\Delta Q_{Si}$ doit être suffisamment grand pour que le dispositif fonctionne : cela implique que la charge générée doit être supérieure à une valeur minimale, ce qui donne une limite inférieure à l'épaisseur du dispositif (l'épaisseur totale de la zone active est dans le mode de réalisation décrit supérieure à 8$\mu$m) ; ceci donne aussi une limite inférieure à la densité de défauts dans la grille piégeante profonde (typiquement la densité doit être strictement supérieure à $10^{18}$cm$^{-3}$), toutes choses étant égales par ailleurs.

$C_{Ox}$ doit être suffisant petit pour que le dispositif fonctionne ; ceci fixe une limite supérieure aux dimensions géométriques du dispositif (typiquement une longueur de grille inférieure à 0,5 $\mu$m et une largeur de dispositif inférieure à 1 $\mu$m), toutes choses étant égales par ailleurs.

Le dispositif peut toutefois être réduit d'un facteur d'échelle n sans que cela affecte le rapport $\Delta Q_{Si} / C_{Ox}$ car si $\Delta Q_{Si}$ passe à $\Delta Q_{Si}$ /n alors $C_{Ox}$ passe à $C_{Ox}$ /n, laissant de ce fait le rapport $\Delta Q_{Si} / C_{Ox}$ inchangé.

La figure 6 illustre schématiquement un élément 300 détecteur d'image comportant un dispositif 1 selon l'invention. Cet élément 300 forme un point de détection (pixel) appartenant typiquement à une matrice (imageur) formée d'une pluralité de lignes et de colonne. L'élément 300 comporte en outre un transistor n-MOS standard 200 supplémentaire.

Les substrats du dispositif 1 et de l'élément 300 sont reliés à la masse.

La source du dispositif 1 selon l'invention est reliée au drain du transistor 200.

Le drain du dispositif 1 est relié à une source de tension Vdd positive.

La grille du dispositif 1 est portée à un potentiel positif par rapport à la masse.

La grille du transistor 200 est reliée à une ligne de sélection SL.

La source du transistor 200 est reliée à une colonne de sortie SC.

Lorsque le transistor 200 est rendu passant via la ligne de sélection SL qui polarise sa grille, le dispositif 1 fonctionne en détecteur avec un courant drain source susceptible d'être modulé par une exposition du dispositif 1 à une source de photons. Le courant drain source modulé du dispositif 1 est récupéré au niveau de la colonne de sortie 1.

Bien entendu, le dispositif et le procédé selon l'invention ne sont pas limités aux modes de réalisation qui viennent d'être décrits à titre indicatif et nullement limitatif en référence aux figures 1 à 6.

Notamment, même si le mode décrit d'obtention de la grille piégeante porte sur un procédé d'implantation ionique, il est également possible de créer la grille piégeante à niveaux profonds par d'autres méthodes. On peut ainsi utiliser des épitaxies successives pour réaliser des couches dopées de telle manière que l'on obtient une zone épitaxiée p- inférieure (sous le caisson), le caisson n (deep n-well), la grille piégeante profonde dopée avec des ions donnant naissance à des niveaux profonds adéquats (piégeant préférentiellement des trous dans le cas d'un MOS à canal n). On peut également réaliser la grille piégeante profonde par bombardement électronique à une énergie donnée, et une dose donnée, avec ajout ou non de couches épitaxiées. De même des plasmas d'ions ou d'électrons peuvent être utilisés dans le procédé d'élaboration de la grille piégeante profonde, combinés à l'épitaxie décrite plus haut.

En outre, on peut fabriquer un dispositif complémentaire en inversant les types de dopage, c'est-à-dire en utilisant des pièges à électrons sur une technologie complémentaire (pour laquelle le matériau n remplace le matériau p et réciproquement). Les pièges de trous deviennent alors des pièges d'électrons.

Par ailleurs, même si l'invention a été plus particulièrement décrite dans le cas d'un substrat massif en silicium, il est également possible d'utiliser un substrat du type silicium sur isolant SOI (« Silicon On Insulator » en anglais).

De même, l'invention a plus spécifiquement décrite dans le cas de l'utilisation d'un semiconducteur cristallin mais on peut aussi envisager d'utiliser du silicium amorphe : une simulation faite en utilisant du silicium amorphe hydrogéné passivé a-Si:H a ainsi montré que le dispositif selon l'invention continue de fonctionner.

Enfin, même si le dispositif selon l'invention trouver une application particulièrement intéressante dans le cas de la détection de photons ou de particules chargées, il convient toutefois de noter que ce dispositif peut également être utilisé en tant que mémoire non volatile. Ainsi, en prévoyant un contact pour l'injection de porteurs correspondant au premier type de dopage dans la zone active (les trous dans le mode de réalisation décrit plus haut), il serait possible d'injecter des porteurs de premier type (i.e. des trous selon le mode de réalisation décrit plus haut) vers la grille piégeante. On peut alors créer une charge positive sur la grille piégeante profonde. Le dispositif agit donc en mémoire volatile. L'injection de trous dans le dispositif 1 représenté en figure 1 peut typiquement être obtenu via un des deux contacts métalliques 9 situées en partie supérieure du substrat 2 assurant respectivement le contact avec les deux zones p+ 8. Le rafraichissement de cette mémoire peut être obtenu par exemple via une ou des électrodes faiblement dopées selon le deuxième type (dopage n selon le mode de réalisation décrit) pour injecter des électrons et permettre une remise à zéro.

## Revendications

**1.** Dispositif semiconducteur (1), en particulier dans un détecteur à semiconducteur, comportant :

- une zone active (3) en matériau semiconducteur dopée selon un premier type de dopage ;
- une zone de drain (4) formée dans ladite zone active (3) et dopée selon un deuxième type de dopage ;
- une zone de source (5) formée dans ladite zone active (3) et dopée selon ledit deuxième type de dopage ;
- une zone de grille (6) isolée séparée de ladite zone active (3) par une couche isolante (7);
- un caisson enterré (12) et dopé selon ledit deuxième type de dopage de sorte que ladite zone active (3) soit localisée entre ladite zone de grille (6) et ledit caisson (12);

ledit dispositif (1) étant **caractérisé en ce qu'**il comporte une zone de grille flottante (13) formée dans ladite zone active (3) sous l'espace (16) existant entre ladite zone de drain (4) et ladite zone de source (5), ladite zone de grille flottante (13) comportant des défauts introduisant des niveaux profonds dans la bande interdite dudit matériau semiconducteur, lesdits niveaux profonds étant aptes à piéger des porteurs correspondant au dit premier type de dopage de sorte que l'état de charge de ladite zone de grille flottante soit modifié et le courant drain source varie du fait de la présence du potentiel supplémentaire sur ladite zone de grille flottante, la concentration de défauts dans ladite zone de grille flottante (13) étant strictement supérieure à $10^{18}$ cm$^{-3}$.

**2.** Dispositif (1) selon la revendication précédente **caractérisé en ce que** ledit caisson enterré (12) a une forme de puits avec une partie basse (14) et une partie latérale (15), ladite partie latérale (15) entourant ladite zone de grille flottante (13).

**3.** Dispositif (1) selon l'une des revendications précédentes **caractérisé en ce que** ladite zone de grille flottante (13) est à proximité dudit espace (16) existant entre ladite zone de drain (4) et ladite zone de source (5).

**4.** Dispositif (1) selon l'une des revendications précédentes **caractérisé en ce que** la concentration de défauts dans ladite zone de grille flottante (13) est supérieure ou égale à $10^{19}$ cm$^{-3}$.

**5.** Dispositif (1) selon l'une des revendications précédentes **caractérisé en ce que** la concentration de défauts dans ladite zone de grille flottante (13) est inférieure ou égale à $10^{21}$ cm$^{-3}$.

**6.** Dispositif (1) selon la revendication précédente **caractérisé en ce que** la concentration de défauts profonds dans ladite zone de grille flottante (13) est sensiblement égale à $10^{20}$ cm$^{-3}$.

**7.** Dispositif (1) selon l'une des revendications précédentes **caractérisé en ce que** la concentration de défauts profonds décroit de ladite zone de grille flottante (13) jusqu'à l'interface entre ladite zone active (3) et ladite couche isolante (7) pour atteindre une concentration inférieure ou égale à $10^{18}$ cm$^{-3}$.

**8.** Dispositif (1) selon l'une des revendications précédentes **caractérisé en ce que** ladite zone de grille flottante (13) est située à une distance comprise entre 0,2 $\mu$m et 5 $\mu$m de l'interface entre ladite zone active (3) et ladite couche isolante (7).

**9.** Dispositif (100) selon l'une des revendications précédentes **caractérisé en ce qu'**une première partie de l'épaisseur (113B) de ladite zone de grille flottante (113) recouvre ledit caisson enterré (112) et que l'autre partie de l'épaisseur (113A) de ladite zone de grille flottante (113) se situe au-dessus dudit caisson enterré (112).

**10.** Dispositif (100) selon la revendication précédente **caractérisé en ce que** ladite zone de grille flottante (113) se situe pour une moitié de son épaisseur sur ledit caisson enterré (112).

**11.** Dispositif (1) selon l'une des revendications précédentes **caractérisé en ce que** ledit premier type de dopage est un dopage p et ledit second type de dopage est un dopage n de sorte que les porteurs piégés dans ladite zone de grille flottante (13) sont des trous.

**12.** Dispositif (1) selon l'une des revendications précédentes **caractérisé en ce qu'**il comporte au moins un contact (17) pour la polarisation dudit caisson enterré (12).

**13.** Dispositif (1) selon l'une des revendications précédentes **caractérisé en ce que** ladite zone de grille isolée (6) a une longueur (L) inférieure ou égale à 0,2 $\mu$m.

**14.** Dispositif (1) selon l'une des revendications précédentes **caractérisé en ce que** ladite zone active (3) a une largeur inférieure ou égale à 1 $\mu$m.

**15.** Dispositif (1) selon l'une des revendications précédentes **caractérisé en ce que** lesdits défauts introduisent des niveaux profonds ayant une section efficace de capture des porteurs issus dudit premier type de dopage supérieure à $10^{-14}$ cm$^2$.

**16.** Dispositif selon l'une des revendications précédentes **caractérisé en ce que** l'énergie d'activation des défauts profonds est de comprise entre 0.3 et 0.5 eV.

**17.** Dispositif (1) selon l'une des revendications précédentes **caractérisé en ce qu'**il comporte un contact (8, 9) pour l'injection de porteurs correspondant au dit premier type de dopage dans ladite zone active (3).

**Fig. 1**

**Fig. 2**

**Fig. 3**

**Fig. 4**

**Fig. 5**

**Fig. 6**

# EP 2 200 083 A2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5943595 A

**Littérature non-brevet citée dans la description**

- **Richter.** Design and technology of DEPFET pixel sensors for linear collider applications. *Nuclear Instruments and Methods in Physics Research A,* 2003, vol. 511, 250-256
- **Fourches et al.** the role of secondary defects in the loss of energy resolution of fast-neutron-irradiated HPGe Gamma-ray detectors. *IEEE Transactions on Nuclear Science,* Décembre 1991, vol. 38 (6), 1728-1735
- **Fourches et al.** Fast neutron irradiation of monolithic active pixel sensors dedicated to particle détection. *8th International Workshop on Radiation Imaging Detectors, Nuclear Instruments and Methods in Physics Research Section A: Accelerators, Spectrometers, Detectors and Associated Equipment,* 11 Juin 2007, vol. 576 (1), 173-177
- **Pearton et al.** Electrical properties of deep silver and iron related centres in silicon. *J. Phys. C: Solid State Phys.,* 1984, vol. 17, 6701-6710
- **Brusa et al.** *Phys. Rev. B,* 15 Mars 1994, vol. 49 (11), 7271-7280
- **Benton et al.** Evolution from point to extended defects in ion implanted silicon. *J. Appl. Phys.,* 01 Juillet 1997, vol. 82 (1), 120-125